(19) Europäisches Patentamt
European Patent Office
Office européen des brevets

(11) **EP 2 431 775 A1**

(12) **EUROPEAN PATENT APPLICATION**

(43) Date of publication:
**21.03.2012 Bulletin 2012/12**

(51) Int Cl.:
***G02B 6/02*** *(2006.01)*        ***G02B 6/293*** *(2006.01)*
***H01S 5/0625*** *(2006.01)*

(21) Application number: **10290494.3**

(22) Date of filing: **16.09.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(71) Applicant: **Alcatel Lucent
75007 Paris (FR)**

(72) Inventors:
• **Debrégeas-Sillard, Hélène
78150 Le Chesnay (FR)**

• **Fortin, Catherine
91460 Marcoussis (FR)**
• **Drisse, Olivier
91760 Itteville (FR)**

(74) Representative: **MERH-IP
Matias Erny Reichl Hoffmann
Paul-Heyse-Strasse 29
80336 München (DE)**

(54) **Interleaved sampled gratings for multi-peaks reflectivity spectrum**

(57)    The present document relates to sampled gratings, in particular interleaved sampled-grating. Furthermore, the present document relates to wide-range tunable semiconductor lasers using such interleaved sampled gratings. A Bragg reflector (600) is described, the reflector (600) comprising a number N of interleaved sampled gratings (200), wherein the sampled gratings (200) have a grating pitch $\Lambda_i$, a segment with grating (601, 602, 603) of length $L_{G,i}$ and a number of grating periods (201) $L_{G,i}/\Lambda_i$ within the segment with grating (601, 602, 603), with i=0,...,N-1 and N>1, respectively. The sampled gratings (200) have a common sampling period (604) of length $L_s$; and the number of grating periods (201) within the segments with grating (601, 602, 603) of at least two sampled gratings (200) are different.

**Fig. 6**

EP 2 431 775 A1

## Description

The present document relates to sampled gratings and a reflector using sampled gratings. Furthermore, the present document relates to wide-range tunable semiconductor lasers such as sampled-grating distributed Bragg reflectors (SGDBR).

## BACKGROUND ART

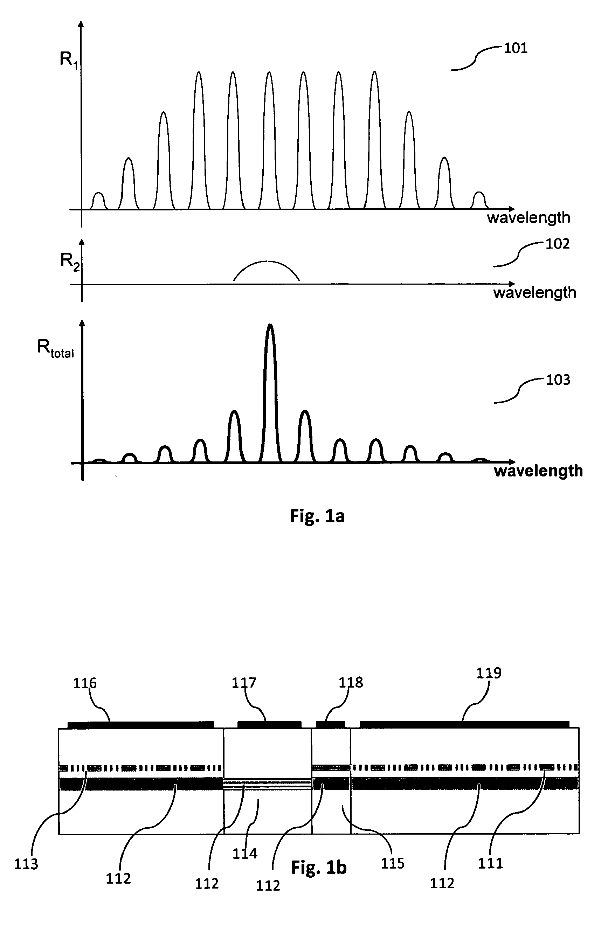

Wavelength tunable lasers, notably lasers for telecommunications applications, are frequently based on the interaction between several wavelength selective filters. As illustrated in Fig. 1a, one of the filters may be a Bragg grating with an additional periodic patterning (a so called Sampled Grating (SG), or SuperStructure Grating (SSG)), providing a comb of reflectivity peaks 101 at wavelengths separated by a few nanometers. A second tunable filter 102 (e.g. using liquid crystals, another SG, multiple Bragg gratings with independent electrodes, Fabry-Perot filter, etc.) may be used to select one of these peaks, to impose the lasing wavelength.

## SUMMARY

A wide-range tunable laser typically requires a perfectly designed multiple peaks spectrum, in order to ensure regular tuning characteristics and coverage at substantially equal power of the whole tuning range (e.g. a tuning range of 40nm and more). In other words, the multiple peaks spectrum should provide several peaks at regular spacing and of equal power across a wide tuning (i.e. frequency) range. This means that it is desirable to have equally strong reflectivity peaks within the tuning range, and small peaks outside this tuning range. The present document addresses this issue and provides a solution which requires relatively low computational complexity and which can be implemented using standard, low cost, manufacturing techniques. In particular, a method of manufacturing a sampled grating and a tunable laser using such sampled gratings is described. Furthermore, a corresponding sampled grating and corresponding tunable laser are described which can be manufactured with standard, low cost, manufacturing techniques.

According to an aspect a method for designing and/or manufacturing a multi-peak Bragg reflector based on sampled gratings is described. The method may comprise the step of interleaving a number N of sampled gratings, wherein N>1. Typically, N is selected to be smaller or equal to 7 or 5 or 3. In an embodiment, N equals 3.

The sampled gratings may be implemented on an optical waveguide, e.g. an optical fiber or a planar waveguide on a photonic integrated circuit (PIC), by periodically altering segments with constant refractive index, i.e. segments without grating, and segments with grating. A segment with grating may comprise a succession of sections with high and low refractive index, with a periodicity referred to as grating pitch $\Lambda$. Each period of the grating, i.e. each succession of a high and low refractive index section, may be referred to as a grating period. The length of a segment with grating may be referred to as $L_G$. The overall length of the sampled grating, i.e. the length of the segment with grating and the length of the segment without grating may be referred to as the length $L_s$ of the sampling period.

As indicated above, the method may comprise the step of interleaving a number N of sampled gratings. Each of the N sampled gratings may have a grating pitch $\Lambda_i$, with i=0,...,N-1, wherein the grating pitches may be different for the N sampled gratings. Each of the N sampled gratings may have a segment with grating of length $L_{G,i}$, with i=0,...,N-1, wherein the lengths of the segment with grating of the N sampled gratings may be different. Each of the N sampled gratings may have a number of grating periods $L_{G,i}/\Lambda_i$, with i=0,...,N-1, within the segment with grating, wherein the number of grating periods per segment with grating may be different for each of the N sampled gratings. The number of grating periods may also be referred to as the number of grating teeth per segment with grating. The N interleaved sampled gratings may have a common sampling period of length $L_s$.

The method may comprise the step of selecting and/or providing the grating pitches $\Lambda_i$ and/or the number of grating periods $L_{G,i}/\Lambda_i$ within the segment with grating, such that the reflector has a pre-determined multi-peak reflection spectrum. The respective number of grating periods within the segment with grating of at least two interleaved sampled gratings may be selected to be different. In other words, the grating pitches $\Lambda_i$ of the N interleaved sampled gratings and/or the lengths $L_{G,i}$ of the respective segments with grating and/or the number of grating periods $L_{G,i}/\Lambda_i$ within the respective segment with grating may be selected to design a pre-determined reflection spectrum of the overall Bragg reflector. The pre-determined multi-peak reflection spectrum may have a substantially rectangular envelope across a certain wavelength range.

The grating pitches $\Lambda_i$ of the N interleaved sampled gratings may be selected and/or provided such that the N interleaved sampled gratings can be written onto an optical waveguide using a pre-determined electron beam grid. In other words, the grating pitches $\Lambda_i$, in particular the difference between the grating pitches, may be selected such that they fall within the resolution of a given manufacturing technology, e.g. the grid imposed by the electron lithography. Consequently, the gratings can be written within one manufacturing cycle, thereby avoiding any phase mismatch between gratings with different pitches.

The grating pitches $\Lambda_i$ may be selected and/or provided such that corresponding central wavelengths $\lambda_{Bragg,i}$, with i=0,...,N-1, of the sampled gratings are spaced by at least 20nm or more. In particular, when reducing the number N of interleaved sampled gratings, the minimum spacing between the central wavelengths $\lambda_{Bragg,i}$ of the reflectivity spectra of the sampled gratings may be increased. As a result of a relatively large spacing between the central wavelengths $\lambda_{Bragg,i}$ with i=0,...,N-1, the requirement of writing the N interleaved sampled gratings onto an optical waveguide using a pre-determined electron beam grid can be more easily met.

According to another aspect, a multi-peak Bragg reflector is described. The multi-peak reflector may also be referred to as an interleaved sampled grating. The reflector may be implemented using a waveguide on an electro-optical material, e.g. a semiconductor material comprising Indium, Gallium, Arsenide and/or Phosphorus. The reflector may comprise a number N of interleaved sampled gratings, N > 1 and N typically being smaller than or equal to 7, 5 or 3. The number N of interleaved sampled gratings may be 3. The N sampled gratings may have grating pitches $\Lambda_i$, respectively. The grating pitches $\Lambda_i$ may be different for some or all of the N sampled gratings. Furthermore, the N sampled gratings may have segments with grating of length $L_{G,i}$, respectively. The lengths $L_{G,i}$ may be different for some or all of the N sampled gratings. The number of grating periods within the segment with grating may be $L_{G,i}/\Lambda_i$ with i=0,..., N-1, respectively. This number $L_{G,i}/\Lambda_i$ may be different for some or all of the N sampled gratings. In particular, the number of grating periods within the segments with grating of at least two sampled gratings may be different.

The N sampled gratings may have a common sampling period of length $L_s$. The reflector may comprise or may span a plurality of sampling periods. The number of sampling periods may be between 5 to 15 sampling periods. In some embodiments, the length $L_s$ of the sampling period is greater than the sum of the lengths $L_{G,i}$, with i=0,...,N-1, of the segments with grating of the N interleaved sampled gratings. The interleaving of the N sampled gratings may be such that the segments with grating of the N sampled gratings are regrouped followed by a common segment with no grating. In particular, the segment with grating of the first sampled grating may be directly followed, i.e. followed directly without an intermediate segment with no grating, by the segment with grating of the second sampled grating, and so on.

The N interleaved sampled gratings may provide a joint reflectivity spectrum, i.e. a reflectivity spectrum of the overall reflector. The reflectivity spectrum may be the result of an overlay of the reflectivity spectra of each of the N sampled gratings. The center frequency of the reflectivity spectrum may be dependent on the grating pitches $\Lambda_i$, with i=0,...,N-1. The width of the reflectivity spectrum may be dependent on the lengths $L_{G,i}$, with i=0,...,N-1, of the segments with grating. The N interleaved sampled gratings may share a common length $L_s$ of a common sampling period and the phases of the N interleaved sampled gratings may be matched. As such, it may be ensured that the reflectivity peaks of the reflectivity spectra of the N sampled gratings coincide.

According to a further aspect a tunable laser comprising an optical waveguide of an electro-optical material is described. The electro-optical material may be a semiconductor material, e.g. a semiconductor material made of Indium, Gallium, Arsenide and/or Phosphorus. In particular, the optical waveguide may be made of InGaAsP. The grating may be obtained by etching an InGaAsP layer on top of optical waveguide, and filling it with lower index InP.

The optical waveguide may comprise a first reflector according to any of the aspects and features outlined in the present document. The first reflector may be positioned at a front side of the waveguide and it may be configured to provide a first reflectivity spectrum. Furthermore, the optical waveguide may comprise a second reflector at a rear side upstream and/or opposite of the front side. The second reflector may be configured to provide a second reflectivity spectrum. In an embodiment, the second reflector is designed according to any of the aspects and features outlined in the present document. In addition, the waveguide may comprise a gain section, between the rear and front side of the waveguide, e.g. downstream of the second reflector and upstream of the first reflector, wherein the gain section may be configured to generate light using the electro-optical material. Furthermore, the waveguide may comprise a phase section between the rear and front side of the waveguide, e.g. downstream of the second reflector and upstream of the first reflector, wherein the phase section is configured to fine tune the Fabry-Perot modes in case of coincidence of a peak of the first and second reflector.

The first reflectivity spectrum may have a first peak and the second reflectivity spectrum may have a second peak, wherein the first and second peaks are misaligned, i.e. the first and second peaks are not at the same wavelength. However, the tunable laser may be configured, i.e. the first and second reflectors may be configured such that the first peak and second peak may be aligned subject to the injection of a current to the first and/or second reflector. As a result of the peak alignment, the tunable laser may generate laser light at a wavelength corresponding to the aligned peaks.

It should be noted that the methods and systems including its preferred embodiments as outlined in the present patent application may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner.

## BRIEF DESCRIPTION OF THE DRAWINGS

Embodiments of the invention are explained below in an exemplary manner with reference to the accompanying drawings, wherein

Fig. 1a is an exemplary illustration of the principle of operation of tunable lasers based on the interaction of a grating generating multiple peaks separated by a few nm, and a widely tunable large filter used for selecting one of the peaks, thereby leading to a maximum reflectivity at the coincidence wavelength of the first and second filter;

Fig. 1b illustrates an example of a tunable laser using a front side and rear side sampled grating;

Fig. 2 provides an exemplary schematic view of a sampled grating, and a corresponding reflectivity peaks spectrum;

Fig. 3 illustrates an example Super Structure Grating (SSG);

Fig. 4 illustrates an example of phase shape of a SSG, and a corresponding reflection spectrum;

Fig. 5 shows an example of a rectangular envelope of the reflectivity (or reflection) spectrum of a SSG, corresponding to the superposition of a large number of shifted SGs;

Fig. 6(a) provides an exemplary schematic view of three interleaved SGs, with three grating pitches ($\Lambda_0$, $\Lambda_1$, $\Lambda_2$), and three lengths ($L_{G0}$ $L_{G1}$, $L_{G2}$) of the segments with grating, respectively;

Fig. 6(b) provides an exemplary presentation of the simulated reflectivity (or reflection) spectra of the three interleaved SGs; and

Fig. 6(c) shows an example of a combined simulated spectrum of the interleaved SGs, for example pitches ($\Lambda_0$, $\Lambda_1$, $\Lambda 2$) and example lengths ($L_{G0}$ $L_{G1}$, $L_{G2}$) of the segments with grating.

## DETAILED DESCRIPTION

Fig. 1b illustrates an example of a tunable laser 110 using two sampled gratings (SG) 111, 113, one at the rear and one at the front side of the tunable laser 110. The tunable laser 110 comprises a waveguide 112 which comprises a gain section 114 and an optional phase shifter section 115 and which traverses or comprises the sampled gratings 111, 113. In an embodiment, the waveguide may be of a semiconductor material e.g. Indium (In) Gallium (Ga) Arsenide (As) Phosphorus (P). The regions of high refractive index (i.e. the dark areas in the figure) of the sampled gratings 111, 113 may comprise a thin layer of InGaAsP, while low refractive index regions (i.e. the light areas in the figure) have this thin layer etched and filled by InP.

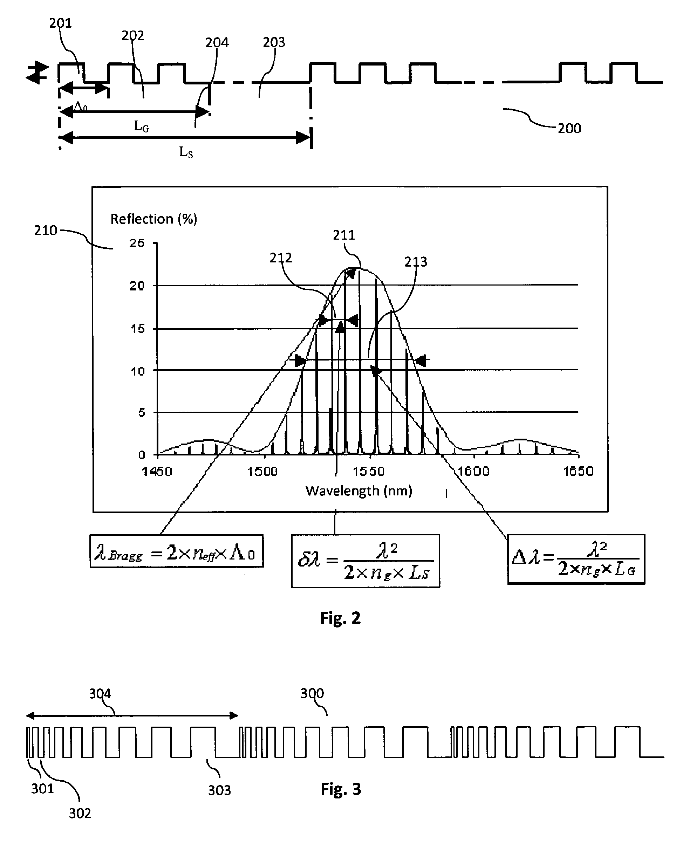

As will be outlined in further detail in the context of Fig. 2, a sampled grating (SG) 111, 113 is a conventional (i.e. continuous) grating with grating elements removed in a periodic fashion. As such, a sampled grating comprises a plurality of segments with grating or grating portions (i.e. portions with periodic changes in refractive index) and a plurality of segments or portions without grating (i.e. segments with no variation of the refractive index). It will be shown that the lengths of the grating portions and the lengths of the portions without grating influence the reflectivity spectrum of the sampled gratings 111, 113. Furthermore, the number of succeeding pairs of grating portions and portions without grating, i.e.

the overall lengths of the sampled gratings 111, 113, influences the total reflectivity of the gratings. Typically, the front grating 113 of a tunable laser 110 is shorter, i.e. has a lower degree of reflectivity, than the rear grating 111, in order to let through a certain fraction of the laser light.

A tunable laser 110 may be manufactured using conventional semiconductor manufacturing techniques. The SGs 111, 113 may be written onto the waveguide material (e.g. InGaAsP) using electron lithography. In order to create a tooth (i.e. a low refractive index section) of the SGs 111, 113, the waveguide material is radiated with an electron beam. Subsequently, the radiated material is etched away and refilled with the low reflectivity index material (e.g. InP). Typically, the electron lithography technology is restricted to a certain grid or resolution which limits the respective distance between high and low index sections, i.e. which limits the variations in the pitch of the SGs 111, 113. In an embodiment, the grid imposed by the lithography technology is of or about 3nm such that the distance between adjacent high refractive index sections is a multiply of or about 3nm. This results in a minimum distance of the Bragg wavelength $\lambda_{Bragg}$ of sampled gratings with different grating pitches of $2*n_{eff}*3nm \sim 20nm$, where $n_{eff}$ is the average refractive index of the sampled gratings (also referred to as the effective index). SGs 111, 113 which require pitch variations that are smaller than the lithography grid typically cannot be manufactured during the same manufacturing step.

The tunable laser 110 comprises a gain section 114 where light, e.g. light in the range of 1550nm, is generated subject to current injected at electrode 117 and reflected within the laser cavity using the SGs 111, 113. The phase shifter section 115 may be adjusted to place a waveguide mode at a particular lasing wavelength subject to current injected at electrode 118. This may be achieved by adjusting the effective length of the laser cavity. The SGs 111, 113 each provide multiple peak spectra 101 as illustrated in Fig. 1a. The multiple-peak spectra 101 of the SGs 111, 113 are slightly mismatched with respect to their periodicity, i.e. with respect to their length $L_s$ of the sampling period, and consequently with respect to the spacing between adjacent reflectivity peaks.

A particular lasing wavelength may be selected by applying a current to one or both of the electrodes 116, 119 of the SGs 111, 113, respectively. The injected current slightly modifies the reflectivity index of the material, thereby slightly shifting the reflectivity spectra 101 of one or both of the SGs 111, 113. As such, a pair of peaks of the reflectivity spectra 101 of the SGs 111, 113 may be aligned, such that lasing occurs at the particular wavelengths of the aligned pair of peaks. In other words, inducing a small index change in one of the SGs 111 relative to the other SG 113 causes adjacent reflectivity maxima to come into alignment, thereby shifting the lasing wavelength by a possibly large amount. This effect may also be referred to as the Vernier effect. This technology may allow implementing tunable lasers 110 with a tuning range of about 50nm at 1550nm, i.e. tunable lasers providing full C band coverage.

As indicated above, a solution to generating the comb of reflection peaks is a Sampled Grating (SG) 200 as illustrated in Fig. 2. A SG 200 comprises a Bragg grating with periodic suppression of the grating teeth. In other words, the SG 200 typically comprises a plurality of grating portions or a plurality of segments with grating 202 of length $L_G$ separated from each other by portions with no grating or segments with no grating 203. The total length of a grating portion 202 and a portion with no grating 203 may be referred to as the sampling period 204 having a length $L_s$. A grating portion 202 is made up of one or more grating periods 201 having a grating pitch $\Lambda_0$. The grating pitch corresponds to the length of one grating period 201. A grating period 201 is defined by a first section of a first (e.g. a high) refractive index $n_1$ followed by a second section of a second (e.g. a low) refractive index $n_2$. Typically, a SG 200 comprises a plurality of succeeding sampling periods 204, thereby influencing the overall reflectivity of the SG 200.

Such SGs 200 can be applied within an optical waveguide (e.g. an optical fiber or a planar waveguide) to generate multi-reflections of the light within the waveguide, wherein the multi-reflection spectrum 210 typically has a cardinal sine (sinc) envelope. It can be shown that the central peak 211 of the envelope of the reflection spectrum 210, i.e. the socalled Bragg wavelength $\lambda_{Bragg}$ is given by

$$\lambda_{Bragg} = 2n_{eff}\Lambda_0 \,,$$

wherein $n_{eff}$ is the effective refractive index of the grating which depends on the first and second refractive indexes $n_1$ and $n_2$. Furthermore, the spacing $\delta\lambda$ (reference numeral 212) between two peaks of the reflectivity spectrum is given by

$$\delta\lambda = \frac{\lambda^2}{2n_g L_S} \,,$$

wherein $\lambda$ is the wavelength of the light, e.g. 1525nm up to 1565nm, and wherein $n_g$ is the group index. In addition, the tuning range $\Delta\lambda$ (reference numeral 213), i.e. the width of the sinc function (at 3 dB), is given by

$$\Delta\lambda = \frac{\lambda^2}{2n_g L_G} \,.$$

Due to the sinc form envelope, a sampled grating 200 provides peaks with unequal power, i.e. unequal peaks. Nevertheless, such SGs 200 are frequently used as reflectors for tunable lasers due to their design and fabrication simplicity. Small grating segments with opposite phase may be used in addition to the grating portions 202 in order to increase the lateral peaks of the reflection spectrum and in order to make the spectrum more rectangular. However, the provision of such grating sections with opposite grating phase typically increases the complexity of the manufacturing process.

Another approach to obtaining a rectangular envelope of the reflection spectrum is the use of a Super Structure Grating (SSG). Fig. 3 illustrates a non interrupted SSG 300. In a similar manner to SG 200, the SSG 300 comprises a plurality of succeeding sampling periods 304. Each sampling period 304 comprises a plurality of grating periods 301, 302, 303 at different grating pitches. As illustrated in Fig. 3, the grating pitch increases from a low pitch grating period 301 at the beginning of a sampling period 304 towards a high pitch grating period 303 at the end of the sampling period 304. The sampling period 304 does not comprise a portion with no grating. Furthermore, neighboring grating periods 301, 302 have different pitches. By using such SSGs 300, the reflection peaks envelope of the reflection spectrum can be designed to be more rectangular. However, the fabrication of such SSGs 300 is complex and time consuming, due to the continuous change of grating pitches within a sampling period 304. As a matter of fact, in order to design an SSG 300 having a reflection spectrum with a rectangular envelope, the difference of the grating pitch of adjacent grating periods 301, 302 is selected to be very small. As such, it is typically not possible to write an SSG 300 into an optical waveguide using a standard electron beam (e-beam) grid (e.g. a grid of 3nm). Consequently, more complex manufacturing techniques are required. In particular, it may be required to perform several e-beam writing cycles, each cycle using a lithography grid which is offset to the previous grid by less than the size of the grid (e.g. by 2 nm). As a result of such multiple writing cycles, the alignment of the different grids may be difficult, thereby causing undesired variations (notably a phase mismatch) in the manufacturing process.

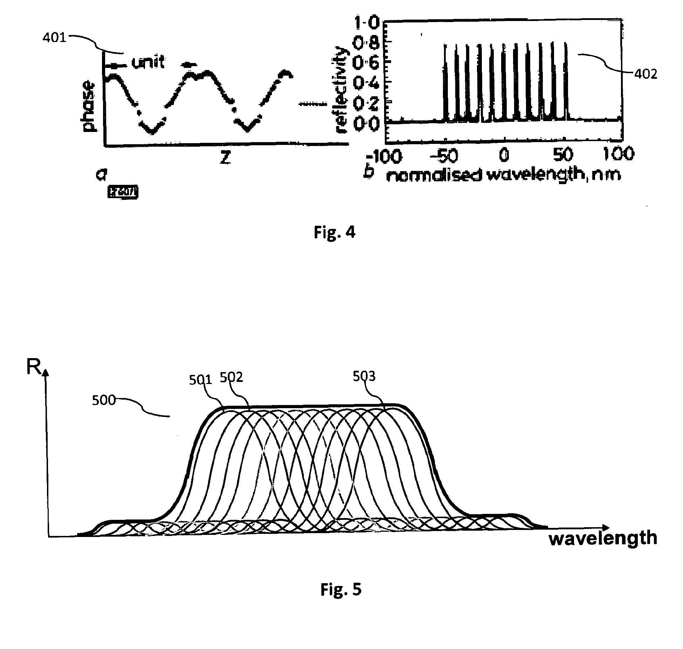

Fig. 4 illustrates an alternative SSG where the grating pitch is kept constant along a sampling period. However, phase discontinuities 401 are periodically inserted into the succession of grating periods. Such phase discontinuities 401 may be inserted by shifting the position of a grating period 201. The position of the phase discontinuities 401 are calculated with an adaptive algorithm. As shown in Fig.4, this solution may be used to provide a reflection spectrum 402 having a rectangular envelop. However, the design of SSGs using phase discontinuities 401 requires important conception work, which is specific to each reflector and/or laser design. Furthermore, it may be complex to reliably control the phase discontinuities 401, i.e. the shift of the grating periods 201, during the manufacturing process. This may require multiple writing cycles using offset lithography grids.

The present document describes a reflector which combines the above principles of SSG and SG. In a preferred embodiment, three interleaved SGs with different grating pitches are used. The grating pitches of the three interleaved SGs are sufficiently apart from one another, in order to be written within the same e-beam (electron beam) grid, thereby leading to short writing times of the gratings and no phase mismatch. Furthermore, a grating structure providing multiple peaks with a rectangular envelope over a wide wavelength range can be determined using calculations of low computational complexity.

As has been outlined in the context of Fig. 2, the SG reflectivity spectrum is defined by its geometrical parameters. In particular, the central wavelength $\lambda_{Bragg}$ of the envelope of the spectrum is influenced by the grating pitch $\Delta_0$, and the spectrum width or tuning range $\Delta\lambda$, is inversely proportional to the grating length $L_G$ per sampling period, also referred to as the length of the grating portion 202.

It is an insight of the present document, that the principle of SSG 300 shown in Fig. 3 can be interpreted as the superposition of a high number of very short SGs 200. In other words, the SSG 300 can be obtained by interleaving a high number of SGs 200, wherein each SG 200 comprises a very short grating portion 202 made up of one grating period 201. Each of the high number of interleaved SGs 200 has a different grating pitch $\Delta_0$ and provides a multiple peaks spectrum with a wide sinc envelope centered at a specific central wavelength $\lambda_{Bragg}$. The grating pitches $\Lambda_0$ of succeeding interleaved SGs 200 are very close to each other, thereby yielding an almost continuous succession of slightly offset sinc-type reflection spectra. The superposition of the high number of reflection (or multiple peaks) spectra 501, 502, 503 is illustrated in Fig. 5. It can be seen that the different reflection spectra 501, 502, 503 are centered at different central wavelengths depending on the grating pitches $\Delta_0$ of the respective SG. The shift of the grating pitches $\Delta_0$, and the resulting shift of the reflection spectra 501, 502, 503 leads to a wide and rectangular envelope of the resulting reflection spectrum 500 of the SSG.

As outlined above, the use of a high number of different grating pitches for the design of an SSG 300 typically requires the use of complex manufacturing techniques. It is therefore proposed to design a multi-peak Bragg reflector by interleaving only a limited number of SGs 200 using different grating pitches. In a preferred embodiment, exactly three SGs 200 having different grating pitches are used for designing the reflector. In other words, it is proposed to use only a restricted number of (e.g. three) interleaved SG 200, with largely separated $\lambda_{Bragg}$ values (typically 20nm), i.e. with largely separated grating pitches. Contrary to SSG 300 where the grating is etched all along the device, i.e. where the grating is present all along a sampling period, it is proposed to design the lengths $L_G$ of the grating portions of the three SGs 200 in order to tailor the respective envelopes (i.e. the width and height) of their respective sinc-type reflection spectra.

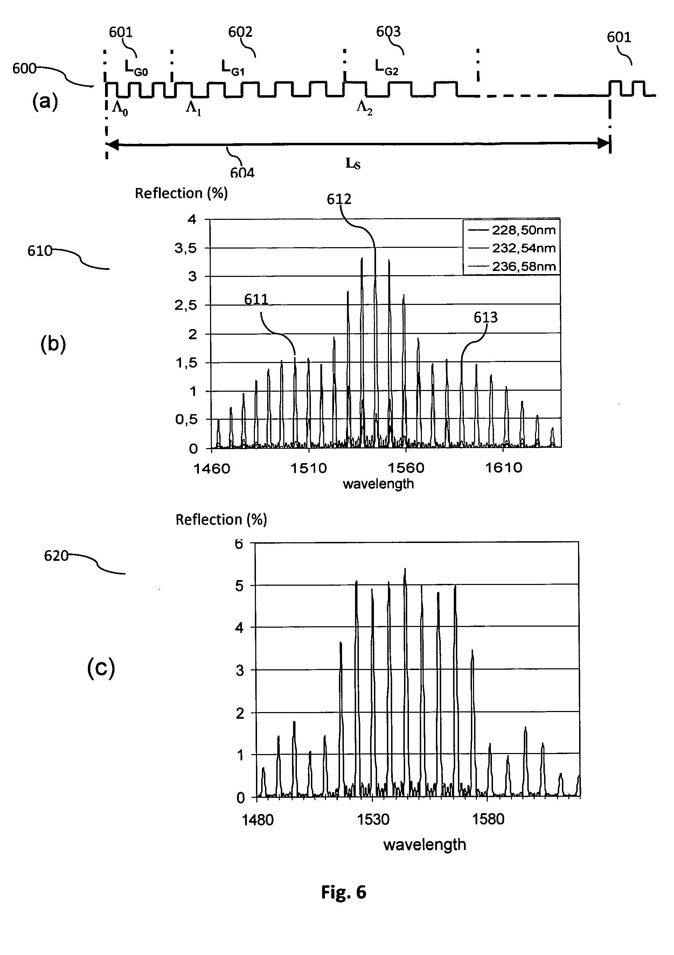

This is illustrated in Fig. 6(a) and Fig. 6(b). It can be seen that the overall reflector 600 comprises a sampling period 604 of length $L_s$. Typically, a reflector 600 comprises a plurality of sampling periods 604. The structure 600 can be considered as three interleaved SGs 200, wherein the first SG uses a grating pitch $\Lambda_0$ with a grating portion 601 of length $L_{G0}$, wherein the second SG uses a grating pitch $\Lambda_1$ with a grating portion 602 of length $L_{G1}$, and wherein the third SG uses a grating pitch $\Lambda_2$ with a grating portion 603 of length $L_{G2}$. The grating pitches $\Delta_0$, $\Lambda_1$, $\Lambda_2$ of the three SGs are selected such that the central wavelengths of the respective reflection spectra 611, 612, 613 are spaced by about 20nm (or more). In particular, the grating pitches $\Lambda_0$, $\Lambda_1$, $\Lambda_2$ may be selected such that the overall grating 600 can be written using the same e-beam lithography grid. In the illustrated example, the different grating pitches correspond to 228.50 nm, 232.54 nm and 236.58 nm, respectively. Furthermore, the respective lengths $L_{G0}$, $L_{G1}$, $L_{G2}$ of the three SGs may be used to vary the width $\Delta\lambda_0$, $\Delta\lambda_1$, $\Delta\lambda_2$ of the reflection spectra 611, 612, 613.

Consequently, the width (or tuning range) and flatness of the overall reflection spectrum 620 can be controlled as shown Fig. 6(c). This can be achieved by simple, i.e. low complexity, simulations (e.g. based on a transfer matrix method). In other words, flat reflectivity peaks 620 can be obtained by using an adequate choice of $\Lambda_0$, $\Lambda_1$, $\Delta_2$, $L_{G0}$, $L_{G1}$, $L_{G2}$ and Ls.

As the grating pitches $\Lambda_0$, $\Delta_1$, $\Delta_2$ are very different from one another, they can be written using the same e-beam lithography grid. Consequently, the writing time of the grating is as short as for a standard grating, and there are no uncontrollable phase discontinuities due to grid modifications, i.e. due to multiple writing cycles using offset lithography grids.

As such, a method for designing a reflector and a corresponding reflector based on sampled gratings has been described. It has been proposed to use a limited number of interleaved sampled gratings, thereby providing an overall reflector which exhibits a wide range multi-peaks reflection spectrum having peaks of substantially equal energy. This can be achieved by adequately selecting the grating pitches of the interleaved sampled gratings and/or the lengths of the grating portions of the sampled gratings. The parameters of the reflector can be determined using low complexity simulation methods. Furthermore, the reflector can be manufactured using standard low cost manufacturing techniques having short writing times. Based on the sampled gratings described in the present document, tunable lasers may be provided which are designed for a full C band coverage tuning range with high power, good power uniformity over the tuning range and good side mode suppression ratios.

It should be noted that the description and drawings merely illustrate the principles of the proposed methods and systems. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Finally, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

**Claims**

1. A method of manufacturing a Bragg reflector (600), the method comprising

   - interleaving a number N of sampled gratings (200), wherein the sampled gratings (200) have a grating pitch $\Delta_i$, a segment with grating (601, 602, 603) of length $L_{G,i}$ and a number of grating periods (201) $L_{G,i}/\Delta_i$ within the segment with grating (601, 602, 603), with i=0,...,N-1 and N>1, respectively, and a common sampling period (604) of length $L_s$; and
   - providing the grating pitches $\Lambda_i$ and/or the number of grating periods (201) $L_{G,i}/\Lambda i$ within the segment with grating (601, 602, 603) such that the reflector (600) has a pre-determined multi-peak reflection spectrum.

2. The method of claim 1, wherein the pre-determined multi-peak reflection spectrum has a substantially rectangular envelope.

3. The method of any previous claim, wherein the grating pitches $\Lambda_i$ are provided such that the N interleaved sampled gratings (200) can be written onto an optical waveguide using a pre-determined electron beam grid.

4. The method of any previous claim, wherein the number N of interleaved sampled gratings (200) is equal to or less than 7.

5. The method of any previous claim, wherein the grating pitches $\Delta_i$ are provided such that corresponding central wavelengths $\lambda_{Bragg,i}$, with i=0,...,N-1, of the sampled gratings (200) are spaced by about 20nm or more.

6. The method of any previous claim, wherein the number of grating periods (201) within the segments with grating (601, 602, 603) of at least two sampled gratings (200) are different.

7. A Bragg reflector (600), the reflector (600) comprising a number N of interleaved sampled gratings (200), wherein

   - the sampled gratings (200) have a grating pitch $\Lambda_i$, a segment with grating (601, 602, 603) of length $L_{G,i}$ and a number of grating periods (201) $L_{G,i}/\Lambda_i$ within the segment with grating (601, 602, 603), with i=0,...,N-1 and N>1, respectively;
   - the sampled gratings (200) have a common sampling period (604) of length $L_S$; and
   - the number of grating periods (201) within the segments with grating (601, 602, 603) of at least two sampled gratings (200) are different.

8. The reflector (600) of claim 7, wherein the length $L_s$ of the sampling period (604) is greater than the sum of the lengths $L_{G,i}$, with i=0,...,N-1, of the segments with grating (601, 602, 603) of the N interleaved sampled gratings (200).

9. The reflector (600) of any of claims 7 to 8, wherein the number N of interleaved sampled gratings (200) is 3.

10. The reflector (600) of any of claims 7 to 9, wherein the reflector comprises a plurality of sampling periods (604).

11. The reflector (600) of any of claims 7 to 10, wherein

    - the interleaved sampled gratings provide a reflectivity spectrum having an envelope;
    - a center frequency of the envelope of the reflectivity spectrum is dependent on the grating pitches $\Lambda_i$, with i=0,...,N-1; and
    - a width of the envelope of the reflectivity spectrum is dependent on the lengths $L_{G,i}$, with i=0,..., N-1, of the segments with grating (601, 602, 603).

12. The reflector of any of claims 7 to 11, wherein the N interleaved sampled gratings have aligned phases.

13. A tunable laser (110) comprising an optical waveguide (112) of an electro-optical material, wherein the optical waveguide (112) comprises

- a first (111) reflector according to any of claims 7 to 12 at a front side of the waveguide (112), configured to provide a first reflectivity spectrum;
- a second reflector (113) at a rear side upstream of the front side, configured to provide a second reflectivity spectrum; and
- a gain section (114), between the rear and front side of the waveguide (112), configured to generate light using the electro-optical material.

14. The tunable laser (110) of claim 13, wherein the electro-optical material is a semiconductor material, e.g. a semiconductor material made of Indium, Gallium, Arsenide and/or Phosphorous.

15. The tunable laser (110) of any of claims 13 to 14, wherein

- the second (113) reflector is according to any of claims 7 to 12;
- a first peak of the first reflectivity spectrum and a second peak of the second reflectivity spectrum are misaligned; and
- the first peak and second peak are aligned subject to the injection of a current to the first (111) and/or second (113) reflector.

**Fig. 1a**

**Fig. 1b**

$$\lambda_{Bragg} = 2 \times n_{eff} \times \Lambda_0$$

$$\delta\lambda = \frac{\lambda^2}{2 \times n_g \times L_S}$$

$$\Delta\lambda = \frac{\lambda^2}{2 \times n_g \times L_G}$$

Fig. 2

Fig. 3

Fig. 4

Fig. 5

**Fig. 6**

Europäisches
Patentamt

European
Patent Office

Office européen
des brevets

# EUROPEAN SEARCH REPORT

Application Number

EP 10 29 0494

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 317 539 B1 (LOH WEI-HUNG [US] ET AL) 13 November 2001 (2001-11-13) * column 1, line 1 - column 6, line 25; figures 1-6 * | 1,2,4-11 | INV. G02B6/02 G02B6/293 H01S5/0625 |
| X | LOH W H ET AL: "Sampled Fiber Grating Based-Dispersion Slope Compensator", IEEE PHOTONICS TECHNOLOGY LETTERS, IEEE SERVICE CENTER, PISCATAWAY, NJ, US, vol. 11, no. 10, 1 October 1999 (1999-10-01), XP011046793, ISSN: 1041-1135 * the whole document * | 1,3,4 | |
| X | GIOANNINI M ET AL: "Novel interleaved sampled grating mirrors for widely tunable DBR lasers", IEE PROCEEDINGS: OPTOELECTRONICS, INSTITUTION OF ELECTRICAL ENGINEERS, STEVENAGE, GB, vol. 148, no. 1, 16 February 2001 (2001-02-16), pages 13-18, XP006016124, ISSN: 1350-2433, DOI: DOI:10.1049/IP-OPT:20010104 | 1,2,4,7, 8,10-14 | |
| Y | * page 13 - page 16; figures 1-8 * | 15 | TECHNICAL FIELDS SEARCHED (IPC) G02B H01S |
| Y | GB 2 371 920 A (MARCONI CASWELL LTD [GB]; MARCONI OPTICAL COMPONENTS LTD [GB]; BOOKHAM) 7 August 2002 (2002-08-07) | 15 | |
| A | * page 1, line 1 - page 7, line 17; figures 1, 2 * | 13,14 | |
| Y | US 2002/061047 A1 (FISH GREGORY A [US] ET AL) 23 May 2002 (2002-05-23) | 15 | |
| A | * paragraphs [0047] - [0051]; figures 2-5 * | 13,14 | |

The present search report has been drawn up for all claims

| Place of search | Date of completion of the search | Examiner |
|---|---|---|
| Munich | 7 March 2011 | Wolf, Steffen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 29 0494

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2011

| Patent document cited in search report | | Publication date | Patent family member(s) | | Publication date |
|---|---|---|---|---|---|
| US 6317539 | B1 | 13-11-2001 | NONE | | |
| GB 2371920 | A | 07-08-2002 | WO | 02063731 A2 | 15-08-2002 |
| US 2002061047 | A1 | 23-05-2002 | US | 2005265420 A1 | 01-12-2005 |

For more details about this annex : see Official Journal of the European Patent Office, No. 12/82